# EUROPEAN PATENT APPLICATION

(11) **EP 4 557 896 A1**
(43) Date of publication of application: **21.05.2025**
(21) Application number: 23307005.1
(22) Date of filing: 20.11.2023
(51) Int. Cl.: H05K 3/42, H05K 1/11, H05K 3/00, H05K 1/18

(54) **METHOD FOR MANUFACTURING VIAS IN A MULTI-LAYERED PCB STACK**

(71) Applicant: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: PERRIN, Rémi, 35708 RENNES CEDEX 7 (FR); AHMED, Ahmed Sabry Eltaher, 35708 RENNES CÉDEX 7 (FR)
(74) Representative: Plasseraud IP

(57) **Abstract**

A method for manufacturing vias in a multi-layered dielectric PCB stack (50) comprising a plurality of alternating first dielectric layers (52) and second dielectric layers (54), the first dielectric layers (52) comprising a first dielectric material with low glass transition temperature (Tg) and the second dielectric layers (54) comprising a second dielectric material with high glass transition temperature (Tg), a plurality of vias (64) being formed (202, 204) into said plurality of first dielectric layers (52) and second dielectric layers (54),
the method comprising:
- at least partially dissolving (206) the first dielectric layers (52) between the vias (64);
- filling (208, 210) with metal (68, 70) the vias (64) and the spaces between the second dielectric layers (54) left void by the at least partial dissolution of the first dielectric layers (52), thus obtaining a metallic network (72) interconnecting the vias (64) each other.

## Description

### TECHNICAL FIELD

The present disclosure relates to a method for manufacturing vias in a multi-layered PCB stack.

### BACKGROUND ART

A classical multi-layer PCB (printed circuit board) uses vias (holes) to interconnect two or more conductive layers. A via is a hole that is mechanically or laser drilled into a dielectric layer and then coated with a conductive metallization (for example copper) in order to electrically and thermally connect at least a top conductive layer and a bottom conductive layer respectively placed above and under the dielectric layer.

In the case of a PCB embedded power die, connections are made with a high density via pattern, in order to have the maximum heat transfer and the lowest electrical resistance.

In fact, in a PCB the heat follows the conductive paths due to better thermal conductivity than in the dielectric layer.

One way to improve the thermal performance of the PCB is to increase the via size and/or the density of the vias. To do so, laser drilling is used to have the smallest via diameter and to cover the connection pad with the maximum number of vias. This known technique comprises successive steps of drilling, chemical copper depositing and surface finishing.

Different techniques of drilling are known which allow getting different size, shape and depth of the vias, with more or less speed and/or precision in the realization of the vias. Document US 5,614,114 discloses a detailed drilling path of a laser head which allows obtaining different sizes of the holes with a same precision. Document US 4,894,115 discloses a technique to drill a cavity in a polymer material. The laser head follows a specific path in order to create the cavity with a specific shape according to the elements to connect. Document EP4095898A1 discloses successive drilling and filling steps allowing increasing the metal density in the PCB, thus improving the thermal resistance. This technique, while offering better thermal performances, increases the manufacturing time, due to multiple successive steps, and the production costs as well. Document US 5,764,485 discloses a specific honeycomb or diagonally arranged via pad that allows obtaining a higher current flow capability by increasing the metal density in the PCB board.

All the above-mentioned solutions suffer from a thermal limitation of the via interconnections. In fact, via interconnection is offering locally a good direct thermal path for dispersion of heat, however, the total surface of the top and bottom conductive layers cannot be contacted (this being referred as "*discrete interconnection*") because the number of vias that can be created in a PCB stack il limited by the drilling technology. This limits the overall heat conduction through the PCB stack and results in a higher thermal resistance in comparison with a direct solder of interconnections ("*silver sintering*" or "*metal-based solder*").

### SUMMARY

The present disclosure aims at improving the situation. In particular, the present disclosure aims at addressing at least in part some or all of the limitations of the prior art discussed above, by proposing a solution enabling to increase the metal density between the top and bottom conductive layers, to allow obtaining a better heat extraction from the PCB stack, and to reduce the intrinsic thermal resistance of the via interconnections.

For this purpose, the present disclosure relates to a method for manufacturing vias in a multi-layered dielectric PCB stack comprising a plurality of alternating first dielectric layers and second dielectric layers, the first dielectric layers comprising a first dielectric material with low glass transition temperature (Tg) and the second dielectric layers comprising a second dielectric material with high glass transition temperature (Tg), a plurality of vias being formed into said plurality of first dielectric layers and second dielectric layers, the method comprising:
- at least partially dissolving the first dielectric layers between the vias;
- filling with metal the vias and the spaces between the second dielectric layers left void by the at least partial dissolution of the first dielectric layers, thus obtaining a metallic network interconnecting the vias each other.

In an embodiment, a permanganate desmear process is performed on the multi-layered dielectric PCB stack to at least partially dissolve the first dielectric layers between the vias.

In an embodiment, to fill the vias with metal an electroless metallic deposition is performed on the multi-layered dielectric PCB stack, thus depositing a first metallic layer on internal walls of the plurality of vias, said first metallic layer also filling the spaces between the second dielectric layers left void by the at least partial dissolution of the first dielectric layers, and then a metallic electroplating filling is performed on the multi-layered dielectric PCB stack, thus filling the plurality of vias with a second metallic layer.

In an embodiment, the first metallic layer (68) and the second metallic layer (70) comprise copper.

In an embodiment, the first dielectric layers comprise acrylic and the second dielectric layers comprise FR4.

In an embodiment, obtaining a plurality of vias comprises:
- placing a top metallic layer above the plurality of first dielectric layers and second dielectric layers;
- etching the top metallic layer according to a predetermined pattern, thus leaving a plurality of masking areas covering the first dielectric layers and the second dielectric layers placed underneath and leaving corresponding uncovered areas where the first dielectric layers and the second dielectric layers are not covered by the top metallic layer;
- drilling the first dielectric layers and the second dielectric layers in correspondence of the uncovered areas, thus obtaining the plurality of vias.

In an embodiment, a bottom metallic layer is placed under the plurality of first dielectric layers and second dielectric layers.

In an embodiment, the top metallic layer comprises copper.

In an embodiment, the bottom metallic layer comprises copper.

In an embodiment, drilling the first dielectric layers and the second dielectric layers comprises mechanically drilling or laser drilling.

In an embodiment, the permanganate desmear process comprises a first sweller step, a second permanganate etching and a third reduction of manganese oxide.

Also provided herein is a multi-layered PCB stack comprising:
- a plurality of alternating first dielectric layers and second dielectric layers, the first dielectric layers comprising a first dielectric material with low glass transition temperature (Tg) and the second dielectric layers comprising a second dielectric material with high glass transition temperature (Tg);
- a plurality of vias drilled into said plurality of first dielectric layers and second dielectric layers, the first dielectric layers being at least partially dissolved between the vias, wherein the vias and the spaces between the second dielectric layers left void by the at least partial dissolution of the first dielectric layers are filled with metal, thus obtaining a metallic network interconnecting the vias each other.

In an embodiment, the multi-layered PCB stack further comprises a top metallic layer placed above the plurality of first dielectric layers and second dielectric layers and a bottom metallic layer placed under the plurality of first dielectric layers and second dielectric layers.

In an embodiment, the top metallic layer and the bottom metallic layer of the multi-layered PCB stack comprise copper.

### BRIEF DESCRIPTION OF DRAWINGS

Further characteristics and advantages of the present invention will become apparent from the following description, provided merely by way of a non-limiting example, with reference to the attached drawings, in which:
- Figures 1(a) - 1(c) show three different ways of drilling a PCB stack;
- Figures 2(a) - 2(c) show the chemical reactions that take place during the three steps of the permanganate desmear sequence;
- Figure shows the steps of a method for manufacturing vias in a multi-layered PCB stack according to the present invention;
- Figure 4 shows a tridimensional view of a multi-layered PCB stack including a metallic network;
- Figure 5 shows a tridimensional view of a PCB stack which does not comprise the metallic network;
- Figure 6(a) shows a sectional view of a first multi-layered PCB stack sample in a first configuration before the desmear process is applied;
- Figure 6(b) shows the first sample of Figure 6(a) the end of the metallic electroplating filling step;
- Figure 7(a) shows a sectional view of a second multi-layered PCB stack sample in a second configuration before the desmear process is applied;
- Figure 7(b) shows the second sample of Figure 7(a) the end of the metallic electroplating filling step 210, and
- Figure 8 shows a sectional view of a reference stack at the end of the metallic electroplating filling step.

### DESCRIPTION OF EMBODIMENTS

The present disclosure relates to a method for manufacturing vias in a multi-layered PCB stack that improves the thermal behavior of the via interconnections.

A via is a hole into a layer of dielectric material forming a PCB stack and isolating two conductive layers, a top and a bottom conductive layer, respectively placed above and below such dielectric material, where the dielectric (epoxy-based) material can be for example acrylic, polyimide or polypropylene based.

The drilling of the via, performed mechanically or by laser, is always followed by a cleaning chemical bath (called desmear). The chemical bath removes the parts of the dielectric material burned, during the drilling step, into the via and/or any remains that are left into the via at the end of the drilling step. Moreover, the chemical bath promotes the adhesion of the metal subsequently deposited in the via by increasing the conductive layer rugosity, as detailed here below, because it cleans the internal walls of the via. The cleaning chemical bath is usually a permanganate-based bath which uses oxidation chemical reaction to roughen the edge of the via.

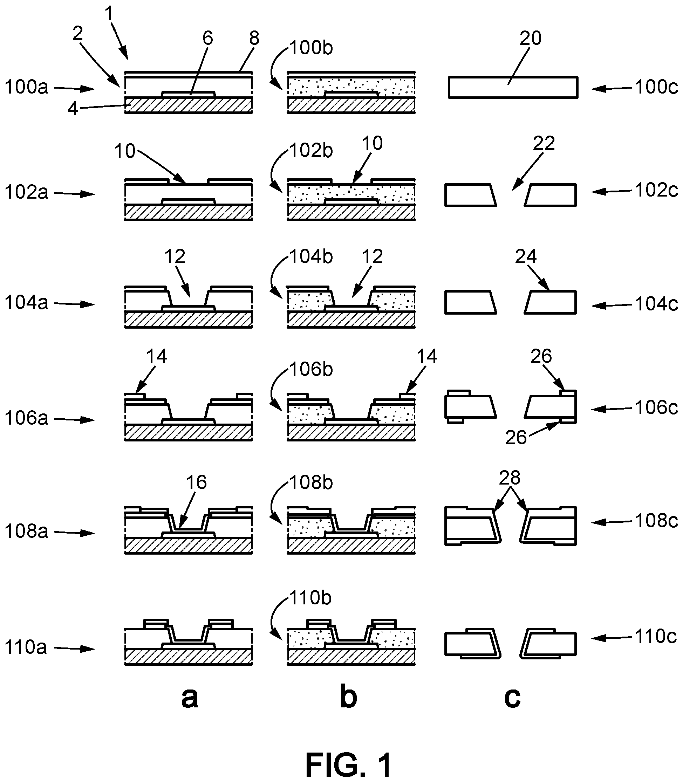

Figure 1(a) - 1(c) show three different ways of drilling a PCB stack. In particular, in Figure 1(a) a UV laser process is shown, in Figure 1(b) a CO₂ laser process is shown and in Figure 1(c) an eximer laser process is shown.

Figure 1(a) shows an initial phase 100a wherein a PCB stack 1 is created, the PCB stack 1, shown in sectional view, including a dielectric layer 2 placed on a substrate 4 with a bottom conductive layer 6 placed in-between and a RCC (resin-coated-copper) layer 8 placed above the dielectric layer 2. In a next phase 102a, the RCC layer 8 is etched with an UV laser and an opening 10 is created. In phase 104a, an UV laser ablation is performed, thus etching the dielectric layer 2 to create a hole (via) 12. Then, in phase 106a, a desmear and metallization processes are performed, and further a mask 14 is deposited on top of the PCB stack 1. Then, in phase 108a, a metallic deposition is performed, to cover the PCB stack 1 and the hole 12 with a metallic layer 16 and finally, in phase 110a, a final etching is performed to remove the mask 14 and the portion of the RCC layer 8 that was under the mask 14.

Figure 1(b) shows an initial phase 100b corresponding to the phase 100a previously disclosed. In a next phase 102b, a chemical copper reduction is performed and the opening 10 is created. In phase 104b, a CO₂ laser ablation is performed, thus obtaining the hole 12. Phases 106b, 108b and 110b correspond to phases 106a, 108a and 110a above disclosed.

Figure 1(c) shows an initial phase 100c wherein a dielectric substrate (layer) 20 is provided. In phase 102c a UV laser ablation is performed, thus etching a hole (via) 22. In phase 104c, a desmear and metallization processes are performed, and a metallic layer 24 in the hole 22 and on top of the substrate 20 is deposited. In a next phase 106c an eximer laser process is performed and then a mask 26 is deposited above and below the substrate 20. In a phase 108c, a metallic deposition is performed, to cover the substrate 20 and the hole 22 with a metallic layer 28. Finally, in phase 110c, a final etching is performed to remove the mask 26.

The permanganate used in the desmear processes above disclosed shows a faster attack on materials with low Tg (glass transition temperature), i.e., with temperature values below 100°C, such as for example acrylic, thus resulting in a deep etching of the material. The speed of dissolution is function of the dielectric material.

Therefore, according to the method for manufacturing vias in a multi-layered PCB stack of the present invention, further disclosed in detail, materials having different values of Tg are used to create the PCB stack, so that it is possible to get controlled vias (cavities) during the desmear process and then to fill such cavities with a metal (e.g., copper) through a metal deposition process.

Therefore, the resulting multi-layered PCB stack contains higher density of metal, thus leading to better thermal performances.

The desmear is a key process to perform prior to the metal deposition (metal plating) to ensure proper adhesion of the metal to the internal walls of the via. Wet treatments are applied during a desmear process.

Among the wet-treatments, alkaline permanganate etching was developed during the 1980's, it is efficient and cheap, and continues to be the most widely used desmear process. Permanganate etching presents the advantages of being more environmentally friendly than chromic acid etching and being readily applicable to a wide class of polymers and composites.

The permanganate desmear process (sequence) consists of three steps: a first sweller step, a second permanganate etching and a third reduction of manganese oxide.

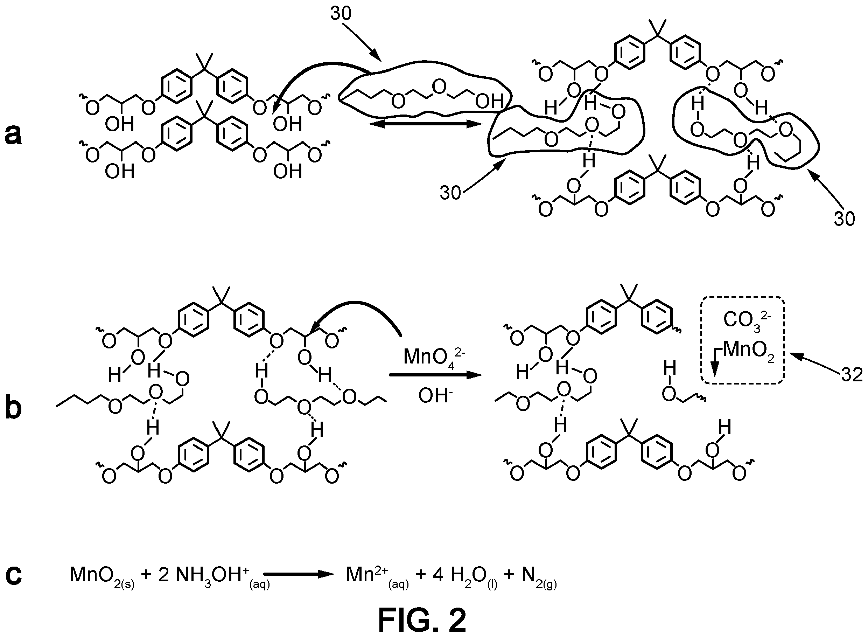

Figures 2(a) - 2(c) show the chemical reactions that take place during the three steps of the permanganate desmear sequence.

In particular in Figure 2(a) sweller molecules 30 diffuse through an epoxy polymer network, in Figure 2(b) permanganate ions MnO₄²⁻ attack the polymers from the surface leading to cavities at the polymer surface (see dotted line 32) and in the equation of Figure 2(c) the MnOz is reactively dissolved by reduction with hydroxylammonium (or peroxide) yielding aqueous manganese ions and gaseous nitrogen (or water).

During the oxidative etching bath, the permanganate ions preferentially attack the polymer chains in the previously formed clusters because of electrostatic interactions. Indeed, it has been determined that the permanganate ions attack both carbons in α-position of the alcohol and ether groups, the inductive effect from the oxygen leading to a weakening of the vicinal carbon-carbon bonds. The conditions of oxidation are strong, leading to an alteration of the burned epoxy, by weakening the vicinal carbon-carbon bonds and removing few micrometers of thickness from the surface in the case of epoxy.

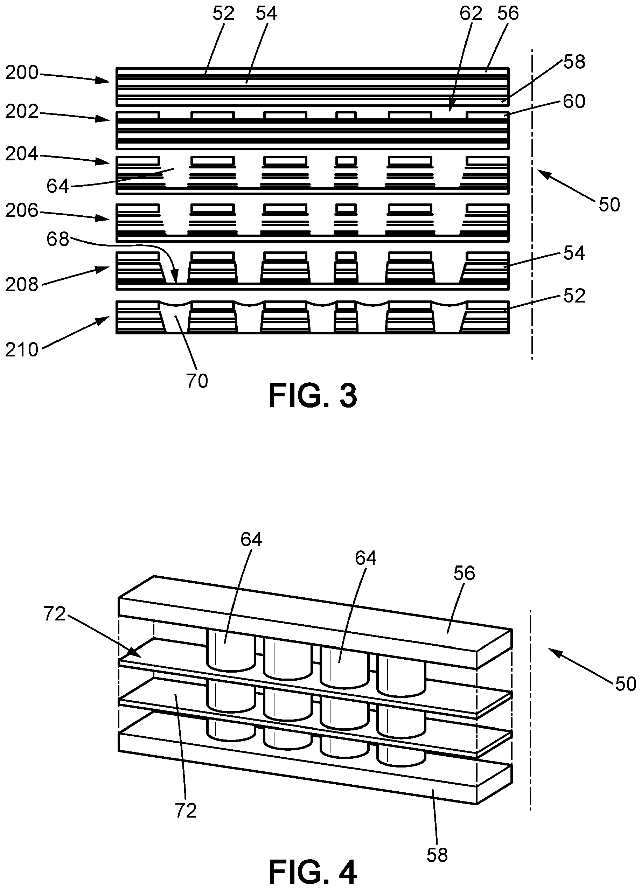

Figure 3 shows the steps of a method for manufacturing vias in a multi-layered PCB stack according to the present invention.

A multi-layered dielectric PCB stack 50, i.e., a PCB stack comprising a plurality of alternating first dielectric layers 52 and second dielectric layers 54, is provided in a first step 200 and it is shown in sectional view on top of Figure 3.

Advantageously, the first dielectric layers 52 comprise a first dielectric material with low Tg such as acrylic and the second dielectric layers 54 comprise a second dielectric material with high Tg such as FR4. In the present description, the expression "*low Tg*" refers to glass transition temperatures below or equal to a threshold value of 100°C. Similarly, the expression "*high Tg*" refers to glass transition temperatures higher than such threshold value of 100°C.The multi-layered PCB stack 50 further comprises a top metallic layer 56 and a bottom metallic layer 58, preferably made of copper, placed above and under the stack of first dielectric layers 52 and second dielectric layers 54 (referred in the following as dielectric stack), respectively.

In a second step 202, the top metallic layer 56 is etched according to a predetermined pattern, thus leaving a plurality of masking areas 60 covering the dielectric stack placed underneath and leaving corresponding uncovered areas 62 where the dielectric stack is not covered by the top metallic layer 56.

Then, in step 204, the dielectric stack is mechanically or laser drilled in correspondence of the uncovered areas 62, thus obtaining a plurality of vias (holes) 64.

In a further step 206, a permanganate desmear process (i.e., the sequence comprising the three baths above-disclosed) is performed on the multi-layered PCB stack 50 and then, in step 208, an electroless metallic deposition is performed on the multi-layered PCB stack 50, thus depositing a first metallic layer 68, preferably copper, on the internal walls of the plurality of vias 64.

During the permanganate desmear process the first dielectric layers 52 at least partially (part of the first dielectric layers 52) dissolve and when the electroless metallic deposition 208 is performed, the first metallic layer 68 also fills the spaces between the second dielectric layers 54 left void by the at least partial dissolution of the first dielectric layers 52.

Alternatively, the first dielectric layers 52 completely dissolve.

As a result, metallic rings around the vias 64, at least partially penetrating into the dielectric stack in correspondence of the fist dielectric layers 52, are formed.

Finally, in step 210, a metallic electroplating filling is performed on the multi-layered PCB stack 50, thus filling the plurality of vias 64 with a second metallic layer 70, preferably copper.

Thanks to the alternance, in the multi-layered PCB stack 50, of first dielectric layers 52 and second dielectric layers 54 with different Tg, the vias 64 become interconnected each other through a metallic network 72 (see Figure 4) made up by the first metal layer 68 replacing the dissolved first dielectric layers 52.

The multi-layered PCB stack 50 comprises therefore a sandwich of materials having different Tg (the first and second dielectric layers 52, 54) in order to get different etching speeds during the desmear process. This results in the erosion of the first dielectric layers 52 during the desmear process, then, the vias 64 and the spaces between the second dielectric layers 54 are filled with a metal during the electroless deposition step 208 and electroplating filling step 210.

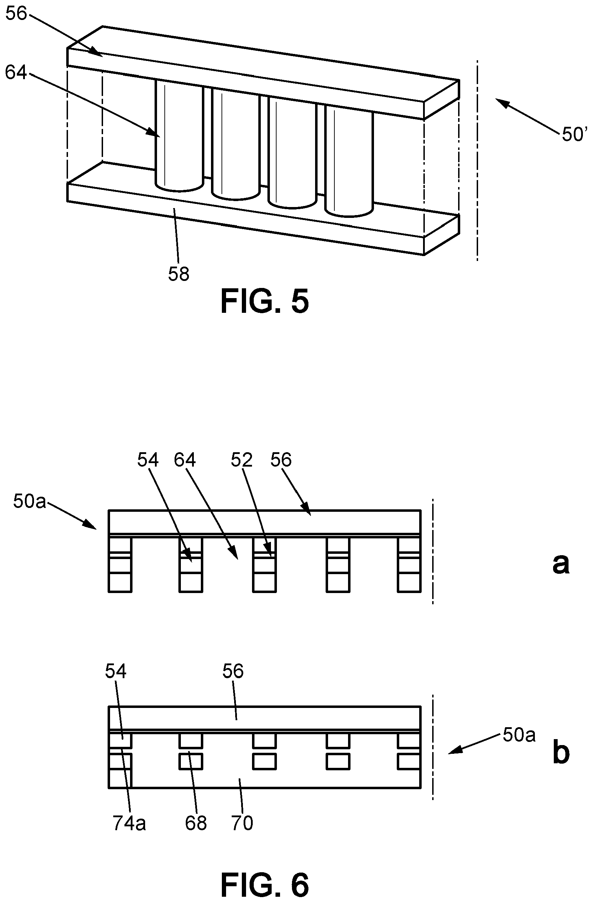

Figure 4 shows a tridimensional view of the multi-layered PCB stack 50 including the metallic network 72 above disclosed while Figure 5 shows a tridimensional view of a PCB stack 50' of the prior art which does not comprise such metallic network 72. In Figure 5 some references corresponding to the ones of Figure 4 have been reported.

As shown in Figure 4, in comparison with the PCB stack 50' of Figure 5, the first metallic layer 68 filling the spaces between the second dielectric layers 54 and previously occupied by the first dielectric layers 52 results in the metallic network 52 interconnecting the plurality of vias 64 and being placed between the top metallic layer 56 and the bottom metallic layer 58.

Table 1 lists different dielectric materials that can be used for the first dielectric layers 52 and the second dielectric layers 54, together with their respective Tg value.

In order to get the best performances during the desmear process, materials having a greater difference between their respective Tg values should be selected as material for the first and second dielectric layers 52, 54, respectively, in order to have the material of the fist dielectric layers 52 (the one with the lower Tg value) dissolved much more than the material of the second dielectric layers 54 (the one with the higher Tg value).

**Table 1**

| **Material** | **Tg [°C]** |
|---|---|
| Polyimide | 250 |
| Polyimide | 260 |
| PPO | 250 |
| PPO | 250 |
| PPO | 250 |
| PTFE | 326 |
| FR4 | 140 |
| FR5 | 180 |
| Acrylic | 45 |
| Bisphenol A | 100 |

In the context of PCB embedded power dies, increasing the density of the metal on the top and/or bottom side of the die helps achieving higher overall heat transfer coefficient of the package, and reducing the junction to ambient thermal resistance (RthJA).

FEM analyses have been carried out for multi-layered PCB stack samples (corresponding to the multi-layered PCB stack 50 above-disclosed) and have been compared to a reference PCB stack sample wherein only one material is used as dielectric layer (corresponding to PCB stack 50' above-shown).

Figure 6(a) shows a sectional view of a first multi-layered PCB stack sample 50a in a first configuration before the desmear process is applied in step 206, wherein in such first configuration only a first dielectric layer 52 is present.

Elements corresponding to the ones of the multi-layered PCB stack 50 above-disclosed are indicated with the same references.

Figure 6(b) shows the first multi-layered PCB stack sample 50a of Figure 6(a) the end of the metallic electroplating filling step 210, wherein the first metallic layer 68 and the second metallic layer 70 have filled the space cleaned from the first dielectric layer 52 during the desmear process.

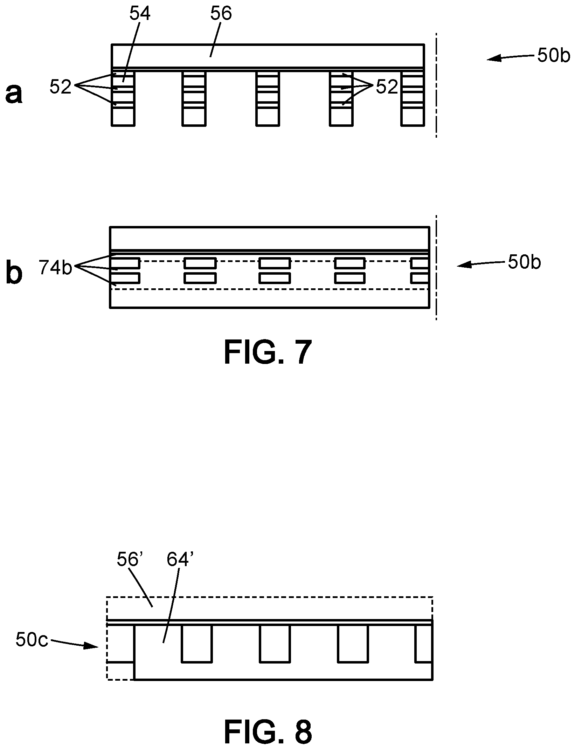

Figure 7(a) shows a sectional view of a second multi-layered PCB stack sample 50b in a second configuration before the desmear process is applied in step 206, wherein in such second configuration three first dielectric layers 52 are present.

Figure 7(b) shows the second multi-layered PCB stack sample 50b of Figure 7(a) the end of the metallic electroplating filling step 210, wherein the first metallic layer 68 and the second metallic layer 70 have filled the spaces cleaned from the first dielectric layer 52 during the desmear process.

Figure 8 shows a sectional view of a reference PCB stack sample 50c at the end of the metallic electroplating filling step 210. The reference stack 50c includes a top conductive layer 56' and vias 64' made up of a single dielectric material.

In the first and second multi-layered PCB stack samples 50a, 50b, on the bottom side, the vias 64 interconnecting the multi-layered PCB stack samples 50a, 50b to an external layer are also interconnected each other by a single fin 74a or three fins 74b.

The thicknesses of the materials in the first and second multi-layered PCB stack samples 50a, 50b have been selected following available materials specifications, in particular FR4 from Panasonic R1766 has been taken for the second dielectric layers 54 (having Tg of 150°C) and an acrylic layer from Dupont LF100 has been taken for the first dielectric layers 52 (having Tg of 45°C).

Table 2 shows the junction to ambient thermal resistance (RthJA) values of the reference PCB stack sample 50c and of the multi-layered PCB stack samples 50a, 50b in the two configurations, where the maximum and minimum junction temperatures, located within the embedded die and at the bottom side of the package are indicated. In a "*Rth benefit"* column is indicated the percentage of improvement of the junction to ambient thermal resistance value of the multi-layered PCB stack samples 50a, 50b with respect to the reference PCB stack sample 50c.

**Table 2**

| **Reference stack** | **Tmax** | **Tmin** | **RthJA** | |
|---|---|---|---|---|
| Embedded die | 114,03 | 104,29 | 4,60 | |
| Bottom side of package | 107,80 | 24,54 | | |
| | | | | |

| **First configuration** | **Tmax** | **Tmin** | **RthJA** | **Rth Benefit** |
|---|---|---|---|---|
| Embedded die | 105,60 | 89,20 | 4,18 | 9% |
| Bottom side of package | 99,40 | 25,30 | | |
| | | | | |

| **Second configuration** | **Tmax** | **Tmin** | **RthJA_max** | **Rth Benefit** |
|---|---|---|---|---|
| Embedded die | 90,70 | 70,90 | 3,44 | 25% |
| Bottom side of package | 84,90 | 25,90 | | |

As shown in Table 2, the results of the FEM simulations indicate a clear improvement of the RthJA value when applied on a single side of the embedded die (25% for three fins). This improvement could be increased by applying this technique to both sides of a die. Moreover, by increasing the density of metal through a higher number of fins, the heat extraction and thus the RthJA further improve.

The method according to the present inventions has also the advantage of allowing manufacturing a multi-layered PCB stack by performing standard process steps because it does not modify the fabricating technique of the PCB stack itself. The improvement of the thermal behavior of the via interconnections is due to the selection of the materials to be used to fabricate the multi-layered dielectric stack, to get the corrosion of the first dielectric layers 52 during the desmear process and further fill with the metal.

Clearly, the principle of the invention remaining the same, the embodiments and details of production can be varied considerably from what has been described and illustrated purely by way of non-limiting example, without departing from the scope of protection of the present as defined in the attached claims.

## Claims

1. A method for manufacturing vias in a multi-layered dielectric PCB stack (50) comprising a plurality of alternating first dielectric layers (52) and second dielectric layers (54), the first dielectric layers (52) comprising a first dielectric material with low glass transition temperature (Tg) and the second dielectric layers (54) comprising a second dielectric material with high glass transition temperature (Tg), a plurality of vias (64) being formed (202, 204) into said plurality of first dielectric layers (52) and second dielectric layers (54),
the method comprising:
- at least partially dissolving (206) the first dielectric layers (52) between the vias (64);
- filling (208, 210) with metal (68, 70) the vias (64) and the spaces between the second dielectric layers (54) left void by the at least partial dissolution of the first dielectric layers (52), thus obtaining a metallic network (72) interconnecting the vias (64) each other.

2. The method of claim 1, wherein at least partially dissolving (206) the first dielectric layers (52) between the vias (64) comprises performing (206) a permanganate desmear process on said multi-layered dielectric PCB stack (50).

3. The method of any of the preceding claims, wherein filling (208, 210) with metal (68, 70) comprises:
- performing (208) an electroless metallic deposition on the multi-layered dielectric PCB stack (50), thus depositing a first metallic layer (68) on internal walls of the plurality of vias (64), said first metallic layer (68) also filling the spaces between the second dielectric layers (54) left void by the at least partial dissolution of the first dielectric layers (52);
- performing (210) a metallic electroplating filling on the multi-layered dielectric PCB stack (50), thus filling the plurality of vias (64) with a second metallic layer (70).

4. The method of claim 3, wherein the first metallic layer (68) and the second metallic layer (70) comprise copper.

5. The method of any of the preceding claims, wherein the first dielectric layers (52) comprise acrylic and the second dielectric layers (54) comprise FR4.

6. The method of any of the preceding claims, further comprising:
- placing a top metallic layer (56) above the plurality of first dielectric layers (52) and second dielectric layers (54);
- etching (202) the top metallic layer (56) according to a predetermined pattern, thus leaving a plurality of masking areas (60) covering the first dielectric layers (52) and the second dielectric layers (54) placed underneath and leaving corresponding uncovered areas (62) where the first dielectric layers (52) and the second dielectric layers (54) are not covered by the top metallic layer (56);
- drilling (204) the first dielectric layers (52) and the second dielectric layers (54) in correspondence of the uncovered areas (62), thus forming the plurality of vias (64).

7. The method of claim 6, further comprising placing a bottom metallic layer (58) under the plurality of first dielectric layers (52) and second dielectric layers (54).

8. The method of claim 6, wherein the top metallic layer comprises copper.

9. The method of claim 7, wherein the bottom metallic layer (58) comprises copper.

10. The method of claim 6, wherein drilling (204) the first dielectric layers (52) and the second dielectric layers (54) comprises mechanically drilling or laser drilling.

11. The method of any of the claims 2 to 10, wherein the permanganate desmear process comprises a first sweller step, a second permanganate etching and a third reduction of manganese oxide.

12. A multi-layered PCB stack (50) comprising:
- a plurality of alternating first dielectric layers (52) and second dielectric layers (54), the first dielectric layers (52) comprising a first dielectric material with low glass transition temperature (Tg) and the second dielectric layers (54) comprising a second dielectric material with high glass transition temperature (Tg);
- a plurality of vias (64) formed into said plurality of first dielectric layers (52) and second dielectric layers (54), the first dielectric layers (52) being at least partially dissolved between the vias (64);
wherein the vias (64) and the spaces between the second dielectric layers (54) left void by the at least partial dissolution of the first dielectric layers (52) are filled with metal (68, 70), thus obtaining a metallic network (72) interconnecting the vias (64) each other.

13. The multi-layered PCB stack (50) of claim 12, further comprising a top metallic layer (56) placed above the plurality of first dielectric layers (52) and second dielectric layers (54) and a bottom metallic layer (58) placed under the plurality of first dielectric layers (52) and second dielectric layers (54).

14. The multi-layered PCB stack (50) of claim 13, wherein the top metallic layer (56) and the bottom metallic layer (58) comprise copper.
